# FASCICULE DE BREVET EUROPEEN

(11) **EP 3 216 753 B1**
(45) Date de publication et mention de la délivrance du brevet: **04.09.2019**
(21) Numéro de dépôt: 17159400.5
(22) Date de dépôt: 06.03.2017
(51) Int. Cl.: B81B 3/00, B81C 1/00

(54) **MEMS COMPORTANT UNE MEMBRANE EN CARBONE AMORPHE**
MEMS MIT EINER MEMBRAN AUS AMORPHEM KOHLENSTOFF
MEMS HAVING AMORPHOUS CARBON MEMBRANE

(30) Priorité: 10.03.2016 FR 1652000
(43) Date de publication de la demande: 13.09.2017
(73) Titulaire: Commissariat à l'Energie Atomique et aux Energies Alternatives, 75015 Paris (FR)
(72) Inventeur: GHIS, Anne, 38400 Saint Martin d'Heres (FR); DELAUNAY, Marc, 38240 Meylan (FR)
(74) Mandataire: Cabinet Camus Lebkiri

(56) Documents cités:
- WO-A1-2014/188710
- M. ARAMESH ET AL: "Ultra-high-density 3D DNA arrays within nanoporous biocompatible membranes for single-molecule-level detection and purification of circulating nucleic acids", NANOSCALE, vol. 7, no. 14, 1 janvier 2015 (2015-01-01), pages 5998-6006, XP055394309, United Kingdom ISSN: 2040-3364, DOI: 10.1039/C4NR07351G
- ISAO AMEMIYA ET AL: "Fabrication of a continuous diamondlike carbon membrane mask for electron projection lithography", JOURNAL OF VACUUM SCIENCE & TECHNOLOGY B: MICROELECTRONICSPROCESSING AND PHENOMENA., vol. 21, no. 6, 1 janvier 2003 (2003-01-01), page 3032, XP055394318, US ISSN: 0734-211X, DOI: 10.1116/1.1618236
- LUO J K ET AL: "Diamond and diamond-like carbon MEMS", JOURNAL OF MICROMECHANICS & MICROENGINEERING, INSTITUTE OF PHYSICS PUBLISHING, BRISTOL, GB, vol. 17, no. 7, 1 juillet 2007 (2007-07-01), pages S147-S163, XP020120165, ISSN: 0960-1317, DOI: 10.1088/0960-1317/17/7/S12

## Description

### DOMAINE TECHNIQUE

L'invention concerne une membrane en carbone amorphe et un microsystème électromécanique (également appelé MEMS) comportant une membrane en carbone amorphe.

### ETAT DE LA TECHNIQUE ANTERIEUR

Les dispositifs de type MEMS à membrane comportent notamment des transducteurs de pression qui sont destinés à être immergés dans un milieu d'immersion liquide ou gazeux. Le milieu d'immersion impose sa pression à la surface d'une membrane suspendue. Celle-ci se déforme sous l'action de cette pression. La valeur mesurée de cette déformation est représentative de la valeur de la pression appliquée. La mesure de déformation peut se faire :
- soit par effet capacitif. Dans ce cas, la membrane déformable est une des armatures d'un condensateur électrique. La déformation modifie la valeur de la capacité, et la variation de capacité est mesurée électriquement.
- soit par effet piézoélectrique. Dans ce cas, des éléments piézoélectriques sont mécaniquement associés à la membrane, de façon à ce que leur déformation soit représentative de la déformation de la membrane. La déformation des éléments piézoélectriques se traduit par l'apparition d'une différence de potentiel électrique entre deux points de l'élément piézoélectrique. Cette différence de potentiel est mesurable, ce qui permet de connaître la déformation de la membrane et la pression appliquée.

Les surfaces des MEMS qui sont en contact avec le milieu extérieur doivent parfois être des barrières hermétiques, unidirectionnelles ou bidirectionnelles, que ce soit pour protéger le milieu extérieur des contaminations liées aux matériaux constituant le MEMS ou que ce soit pour protéger le MEMS des agressions du milieu extérieur. Ainsi, une barrière de protection permettant de protéger le milieu extérieur des contaminations liées au MEMS est par exemple nécessaire lorsque le MEMS est introduit dans un milieu biologique. Une barrière de protection peut également être nécessaire lorsque le MEMS est introduit dans un milieu agressif ou corrosif. Une barrière de protection hermétique peut également être nécessaire pour maintenir une atmosphère contrôlée à l'intérieur du MEMS, par exemple en cas de diffusion de gaz.

Pour ce faire, il est connu d'utiliser des revêtements de protection sur les membranes des MEMS. Les revêtements de l'art antérieur peuvent être des métaux, des oxydes, des composés azotés ou carbonés, ou encore des polymères. Les critères de choix sont l'inertie chimique, la biocompatibilité, l'herméticité, la transparence électromagnétique pour les dispositifs communicants, et les techniques de dépôt. M. ARAMESH ET AL: "Ultra-high-density 3D DNA arrays within nanoporous biocompatible membranes for single-molecule-level détection and purification of circulating nucleic acids", NANOSCALE, vol. 7, no. 14, 1 janvier 2015 (2015-01-01), pages 5998-6006, United Kingdom ISSN: 2040-3364, DOI: 10.1039/C4NR07351G décrit une membrane comportant une membrane principale revêtue par une membrane en carbone amorphe, la membrane en carbone amorphe présentant une épaisseur comprise entre 1 nm et 50.

Toutefois, le revêtement ne doit pas modifier la rigidité de la membrane mobile du MEMS. Or il est difficile de trouver un revêtement qui ne modifie pas la rigidité de la membrane du MEMS, et qui présente dans le même temps les caractéristiques nécessaires en termes d'inertie chimique, de biocompatibilité et d'herméticité.

### EXPOSE DE L'INVENTION

L'invention vise à remédier aux inconvénients de l'état de la technique en proposant, selon la revendication 1, un microsytème électromécanique comportant une membrane qui soit suffisamment souple pour ne pas fausser significativement le fonctionnement du MEMS, tout en étant biocompatible, hermétique, inerte chimiquement et transparente électromagnétiquement.

Pour ce faire, ladite membrane est une membrane en carbone amorphe, la membrane présentant une épaisseur comprise entre 1 nm et 50 nm, et de préférence comprise entre 3 nm et 20 nm.

Une telle membrane présente l'avantage d'être chimiquement inerte, biocompatible, et hermétique même en épaisseurs nanométriques, et stable jusqu'à des températures supérieures à 300°C. En outre, une membrane de carbone amorphe d'une telle épaisseur présente l'avantage d'avoir une rigidité suffisamment faible pour ne pas altérer le fonctionnement du microsystème électromécanique, tout en gardant ses propriétés d'inertie chimique et d'herméticité.

La membrane en carbone amorphe présente un taux d'hybridation de type sp³ compris entre 20% et 40% ce qui lui permet de présenter un module d'Young compris entre 100 GPa et 500 GPa.

Selon l'invention
- la membrane mobile peut comporter comme seule membrane la membrane en carbone amorphe. Dans ce cas, la membrane en carbone amorphe constitue la membrane mobile du microsystème électromécanique, sans qu'il soit nécessaire de la doubler d'une autre membrane. Ce mode de réalisation permet de réaliser un microsystème électromécanique dont la membrane mobile est très souple ;
- la membrane mobile peut comporter une membrane principale, la membrane principale étant revêtue par la membrane en carbone amorphe. Dans ce cas, la membrane en carbone amorphe forme un revêtement protecteur déposé sur la membrane principale du microsystème électromécanique;
- le microsystème électromécanique est un actionneur ou un capteur.

Selon différents modes de réalisation :
- le microsystème électromécanique peut être un transducteur capacitif ;
- le microsystème électromécanique peut être un transducteur piézoélectrique.

### BREVES DESCRIPTION DES FIGURES

D'autres caractéristiques et avantages de l'invention ressortiront à la lecture de la description détaillée qui suit, en référence aux figures annexées, qui représentent :
- La figure 1, une représentation schématique d'un microsystème électromécanique selon un mode de réalisation de l'invention ;
- La figure 2, une représentation schématique d'un microsystème électromécanique selon un autre mode de réalisation de l'invention ;
- La figure 3, une représentation schématique d'un microsystème électromécanique selon un autre mode de réalisation de l'invention ;
- La figure 4, une représentation schématique d'un microsystème électromécanique selon un autre mode de réalisation de l'invention.

### DESCRIPTION DETAILLEE D'AU MOINS UN MODE DE REALISATION

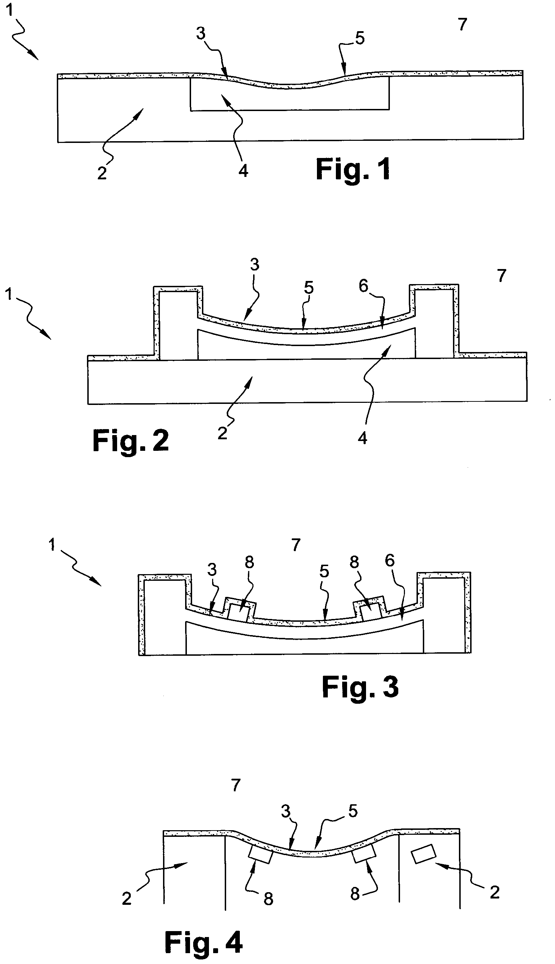

La figure 1 représente un microsystème électromécanique 1 selon un mode de réalisation de l'invention. Ce microsystème électromécanique 1 est un transducteur capacitif. Il comporte une armature fixe 2 et une membrane mobile 3, séparées par une cavité 4. Le déplacement de la membrane mobile 2 peut-être provoqué soit par une pression du milieu extérieur 7 si le transducteur fonctionne en mode capteur, soit par une tension électrique si le transducteur fonctionne en mode actionneur.

La membrane mobile 3 comporte une membrane en carbone amorphe 5. Cette membrane en carbone amorphe 5 présente une épaisseur comprise entre 2 nm et 50 nm.

La figure 2 représente un microsystème électromécanique selon un autre mode de réalisation de l'invention. Ce microsystème électromécanique 1 est un transducteur capacitif. Il comporte une armature fixe 2 et une membrane mobile 3, séparées par une cavité 4. Le déplacement de la membrane mobile 3 peut-être provoqué soit par une pression du milieu extérieur 7 si le transducteur fonctionne en mode capteur, soit par une tension électrique si le transducteur fonctionne en mode actionneur.

La membrane mobile 3 comporte une membrane principale 6 revêtue par une membrane en carbone amorphe 5. La membrane en carbone amorphe 5 présente une épaisseur comprise entre 1 nm et 50 nm, et de préférence comprise entre 3 nm et 20 nm, de façon à ce qu'elle ne modifie pas la rigidité de la membrane principale 6. La membrane en carbone amorphe 5 peut être déposée soit par dépôt direct sur la membrane principale, soit par report de couche.

La figure 3 représente un autre mode de réalisation dans lequel le microsystème électromécanique 1 est un transducteur piézoélectrique. Dans ce mode de réalisation, le microsystème électromécanique comporte une membrane mobile 3 sur laquelle est fixé au moins un capteur piézoélectrique 8 ou un actionneur piézoélectrique 8. La membrane mobile 3 comporte, comme dans le mode de réalisation précédent, une membrane principale 6 revêtue par une membrane en carbone amorphe 5. La membrane en carbone amorphe 5 présente une épaisseur comprise entre 1 nm et 50 nm, et de préférence comprise entre 3 nm et 20 nm, de façon à ce qu'elle ne modifie pas la rigidité de la membrane principale 6. La membrane en carbone amorphe peut être déposée soit par dépôt direct sur la membrane principale, soit par report de couche.

En référence à la figure 4, on pourrait également envisager que la membrane mobile ne comprenne que la membrane en carbone amorphe comme dans le mode de réalisation de la figure 1. Dans ce cas, les capteurs ou actionneurs piézoélectriques sont de préférence fixés sous la membrane. En d'autres termes, dans ce cas, la membrane comporte une première face destinée à être en contact avec le milieu extérieur 7 et une deuxième face sur laquelle sont fixés le ou les capteurs ou actionneurs piézoélectriques 8. L'avantage de cette configuration est que la rigidité de la membrane est minimale, et donc la transduction entre le mouvement mécanique de la membrane et le signal électrique aux bornes des capteurs ou actionneurs piézoélectriques, pour la commande ou la lecture, se fait à énergie minimale. La membrane en carbone amorphe présente de préférence une épaisseur comprise entre 2 nm et 50nm, déterminée en fonction du positionnement des capteurs ou actionneurs piézoélectriques 8.

La membrane en carbone amorphe utilisée dans les microsystèmes électromécaniques des figures 1 à 4 présente un taux d'hybridation de type sp³ compris entre 20% et 40% ce qui lui permet de présenter un module d'Young compris entre 100 GPa et 500 GPa. En effet, les atomes de carbone hybrident leurs orbitales externes s et p en sp² et sp³ pour former des liaisons de type π ou σ, le taux relatif de ces liaisons est déterminant pour les propriétés du matériau : globalement, les liaisons π régissent le comportement électronique de la membrane, et les liaisons σ en déterminent le comportement mécanique. Le taux d'apparition de chacune des deux liaisons dans le matériau peut être déterminé expérimentalement par spectrométrie photoélectronique X ou par spectroscopie Raman. L'échantillon doit être dégazé lors de la mesure.

La membrane en carbone amorphe est flexible. En effet, la membrane en carbone amorphe présente un module de Young compris entre 100 GPa et 500 GPa.

La membrane en carbone amorphe 5 est chimiquement inerte, biocompatible, hermétique même en épaisseurs nanométriques, et stable jusqu'à des températures supérieures à 300°C. La membrane en carbone amorphe 5 permet à la fois de protéger la membrane principale 6 des agressions du milieu extérieur 7 et également de protéger le milieu extérieur des contaminations générées par la membrane principale 6 , le support 2, et l'ensemble des éléments du MEMS, ce qui est particulièrement intéressant lorsque le milieu extérieur est un milieu biologique.

Une telle membrane en carbone amorphe peut par exemple être fabriquée dans le dispositif décrit dans la demande FR 3 042 797. En effet, ce dispositif permet de fabriquer des couches en carbone amorphe de faible épaisseur, continues, homogènes, élastiques, dont le taux de liaison sp³ est supérieur à 20%, et sur tout type de substrat.

Naturellement, l'invention n'est pas limitée aux modes de réalisation décrits en référence aux figures et des variantes pourraient être envisagées sans sortir du cadre de l'invention. La membrane en carbone amorphe pourrait par exemple être utilisée dans d'autres microsystèmes électromécaniques que ceux décrits en référence aux figures.

## Revendications

1. Microsystème électromécanique (1) dans lequel le microsystème électromécanique est un actionneur ou un capteur, ledit microsystème électromécanique comportant une membrane mobile (3) comportant soit une membrane principale (6) revêtue par une membrane en carbone amorphe (5) soit uniquement une membrane en carbone amorphe (5), la membrane en carbone amorphe (5) présentant une épaisseur comprise entre 1 nm et 50 nm, et de préférence comprise entre 3 nm et 20 nm, dans laquelle la membrane en carbone amorphe présente un taux d'hybridation de type sp³ compris entre 20% et 40%.

2. Microsystème électromécanique (1) selon la revendication 1, dans lequel le microsystème électromécanique est un transducteur capacitif.

3. Microsystème électromécanique (1) selon la revendication 1, dans lequel le microsystème électromécanique est un transducteur piézoélectrique.

## Patentansprüche

1. Elektromechanisches Mikrosystem (1), bei dem das elektromechanische Mikrosystem ein Stellorgan oder ein Sensor ist, wobei das genannte elektromechanische Mikrosystem eine mobile Membran (3) umfasst, umfassend entweder eine Hauptmembran (6), die mit einer Membran aus amorphem Kohlenstoff (5) beschichtet ist, oder nur eine Membran aus amorphem Kohlenstoff (5), wobei die Membran aus amorphem Kohlenstoff (5) eine zwischen 1 nm und 50 nm inbegriffene und bevorzugt zwischen 3 nm und 20 nm inbegriffene Dicke aufweist, bei der die Membran aus amorphem Kohlenstoff einen Hybridisierungsgrad von Typ sp³ aufweist, der zwischen 20 % und 40 % inbegriffen ist.

2. Elektromechanisches Mikrosystem (1) gemäß Anspruch 1, bei dem das elektromechanische Mikrosystem ein kapazitiver Transduktor ist.

3. Elektromechanisches Mikrosystem (1) gemäß Anspruch 1, bei dem das elektromechanische Mikrosystem ein piezoelektrischer Transduktor ist.

## Claims

1. A microelectromechanical system (1), wherein the microelectromechanical system is an actuator or a sensor, said microelectromechanical system including a moving membrane (3) including either a main membrane (6) coated with a membrane of amorphous carbon (5) or only a membrane of amorphous carbon (5), the membrane of amorphous carbon (5) having a thickness between 1nm and 50nm, and preferably between 3nm and 20nm, wherein the membrane of amorphous carbon has a sp³ type hybridisation rate between 20% and 40%.

2. The microelectromechanical system according to claim 1, wherein the microelectromechanical system is a capacitive transducer.

3. The microelectromechanical system according to claim 1, wherein the microelectromechanical system is a piezoelectric transducer.
